(19) Europäisches Patentamt
European Patent Office
Office européen des brevets

(11) **EP 1 779 057 B1**

(12) **EUROPÄISCHE PATENTSCHRIFT**

(45) Veröffentlichungstag und Bekanntmachung des Hinweises auf die Patenterteilung:
**16.01.2008  Patentblatt 2008/03**

(21) Anmeldenummer: **05756901.4**

(22) Anmeldetag: **23.06.2005**

(51) Int Cl.:
*G01B 7/06* *(2006.01)*

(86) Internationale Anmeldenummer:
**PCT/EP2005/052926**

(87) Internationale Veröffentlichungsnummer:
**WO 2006/005673 (19.01.2006 Gazette 2006/03)**

(54) **VERFAHREN ZUR BERÜHRUNGSFREIEN BESTIMMUNG EINER SCHICHTDICKE DURCH WIDERSTANDS- UND INDUKTIVITÄTSMESSUNG EINER SENSORSPULE**

METHOD FOR DETERMINING IN A CONTACTLESS MANNER THE THICKNESS OF A LAYER BY RESISTANCE AND INDUCTIVITY MEASUREMENT OF A SENSOR COIL

PROCEDE DE DETERMINATION SANS CONTACT D'UNE EPAISSEUR DE COUCHE PAR MESURE DE LA RESISTANCE ET DE L'INDUCTANCE D'UNE BOBINE DE CAPTEUR

(84) Benannte Vertragsstaaten:
**CH DE ES FR GB IT LI**

(30) Priorität: **15.07.2004  DE 102004034083**

(43) Veröffentlichungstag der Anmeldung:
**02.05.2007  Patentblatt 2007/18**

(73) Patentinhaber: **ROBERT BOSCH GMBH**
**70442 Stuttgart (DE)**

(72) Erfinder:
• **HACHTEL, Hansjörg**
  **71287 Weissach (DE)**
• **MEYER, Stefan**
  **71701 Schwieberdingen (DE)**

(56) Entgegenhaltungen:
**WO-A-99/58923**          **US-A1- 2003 210 042**

EP 1 779 057 B1

**Beschreibung**

Stand der Technik

Die Erfindung geht von dem aus DE 196 52 750 C2 bekannten Verfahren zur Bestimmung einer Dicke einer Schicht aus elektrisch leitendem Material, insbesondere einer Chromschicht, aus. Das Verfahren beruht auf einer Kombination von Induktiv- und Wirbelstromprinzip. Zur Durchführung des Messverfahrens wird ein Sensor, der aus einer Spule und einem Spulenkörper besteht, mit Hilfe einer Feder gegen die Oberfläche eines zu messenden Bauteils gedrückt. Mehrere Mess- und Auswerteschritte, bei denen die Spule von einem Wechselstrom durchflossen und ihre Induktivitätsänderung ausgewertet wird, führen zur Bestimmung der Dicke der Schicht. Dabei auftretende Messfehler, verursacht beispielsweise durch Schwankungen der stofflichen Beschaffenheit des Bauteils oder durch Verschmutzung oder Abrieb bewirkte Unterschiede des Abstandes zwischen der Spule und dem Bauteil, können durch die Einführung eines Normwertes vermindert werden. Auch wird dadurch eine eindeutige Zuordnung zwischen dem gemessenen Induktivitätswert und der entsprechenden Schichtdicke gewährleistet.

Die WO-A-99 58 923 beschreibt ein Verfahren zur Bestimmung der Dicke einer leitenden Schicht auf einem ferromagnetischen Substrat mit Hilfe einer wechselstromdurchflossenen Spule. Dabei wird erst die Induktivität der Spule bei einer gegebenen Frequenz gegenüber dem unbeschichteten Substrat gemessen und danach die Induktivität der Spule bei derselben Frequenz gegenüber dem beschichteten Substrat. Diese Messwerte werden in einen dimensionslosen Wert umgewandelt der mit Hilfe einer Justierkurve in die Schichtdicke umgewandelt wird.

Vorteile der Erfindung

Das erfindungsgemäße Verfahren zur Bestimmung einer Dicke einer Schicht aus elektrisch leitendem Material mit den Merkmalen des unabhängigen Anspruchs hat den Vorteil, dass eine berührungsfreie Messung ermöglicht wird. Dadurch wird ein für das Messobjekt schonendes, schnelles Verfahren bereitgestellt. Zudem wird die Gefahr einer Sensor- und/oder Oberflächenbeschädigung eliminiert.

Weiter wird bei bisherigen Kontaktmessungen das Messobjekt mit der zu untersuchenden Schicht auf einem federnd gelagerten Spulenkörper aufgesetzt und gegen diesen angedrückt, um eine planparallele Kontaktierung des Messobjektes mit dem Spulenkörper zu gewährleisten. Dabei werden die zur Spule führenden Spulen-Anschlußdrähte unweigerlich mitbewegt und können daher nach wiederholten Messungen durch eine starke Abnutzung brechen. Bei der erfindungsgemäßen, berührungsfreien Messung wird eine Bewegung des Spulenkörpers und somit ein Bruch der Spulen-Anschlußdrähte vermieden.

Bei einer berührungsfreien Messung kann grundsätzlich eine nicht zu vernachlässigende Fertigungstoleranz des Messobjektes problematisch werden. Aufgrund einer Fertigungstoleranz ungleich Null schwankt möglicherweise der Luftspalt, d. h. der Abstand zwischen dem Spulenkörper, und damit der Spule und dem Messobjekt, von Messung zu Messung. Eine daraus folgende Verfälschung der Messergebnisse wird durch das erfindungsgemäße Verfahren vermieden, so dass das Messobjekt nicht bei jedem Messzyklus gegen den Spulenkörper gedrückt werden muss, um eine Schwankung des Abstandes zu vermeiden.

Dabei weist das Verfahren auch alle Vorzüge auf, die das Verfahren aus dem Stand der Technik bietet. Insbesondere in einer Massenproduktion hergestellte beschichtete Teile können in einem kontinuierlich durchlaufenden Meßverfahren überprüft werden.

Durch die in den abhängigen Ansprüchen und in der Beschreibung aufgeführten Maßnahmen sind vorteilhafte Weiterbildungen und Verbesserungen des im unabhängigen Anspruch angegebenen Verfahrens möglich.

Zeichnung

Ein Ausführungsbeispiel der Erfindung ist in der Zeichnung dargestellt und in der nachfolgenden Beschreibung näher erläutert.

Die Figur 1 zeigt einen schematischen Aufbau der Meßvorrichtung.

In der Figur 2 ist der Verlauf der Induktivität L der Meßspule über die Dicke a der zu bestimmenden Schicht bei unterschiedlichen Abständen und bei unterschiedlicher stofflicher Beschaffenheit $\alpha$ bzw. $\beta$ des sich unter der zu bestimmenden Schicht befindlichen Materials dargestellt.

In der Figur 3 ist das Verhältnis der in Figur 2 verwendeten unterschiedlichen Abstände zwischen der Meßspule und dem Meßobjekt dargestellt.

Figur 4 zeigt den Verlauf der Spuleninduktivität L in Abhängigkeit der eingesetzten Frequenz bei unterschiedlichen Luftspalten (Abstand Spulenkörperunbeschichtetes Messobjekt).

Figur 5 zeigt den Verlauf des Spulenwiderstands R in Abhängigkeit der eingesetzten Frequenz bei unterschiedlichen Luftspalten (Abstand Spulenkörperunbeschichtetes Messobjekt).

Figur 6 zeigt eine Abstandskennlinie, mit der ein Widerstandswert R in einen Abstandswert d umgewandelt werden kann.

Figur 7 zeigt eine Justierkurvenschar mit mehreren Justierkurven, wobei jede einzelne für einen konkreten, voneinander unterschiedlichen Abstand d gilt.

Beschreibung des Ausführungsbeispiels

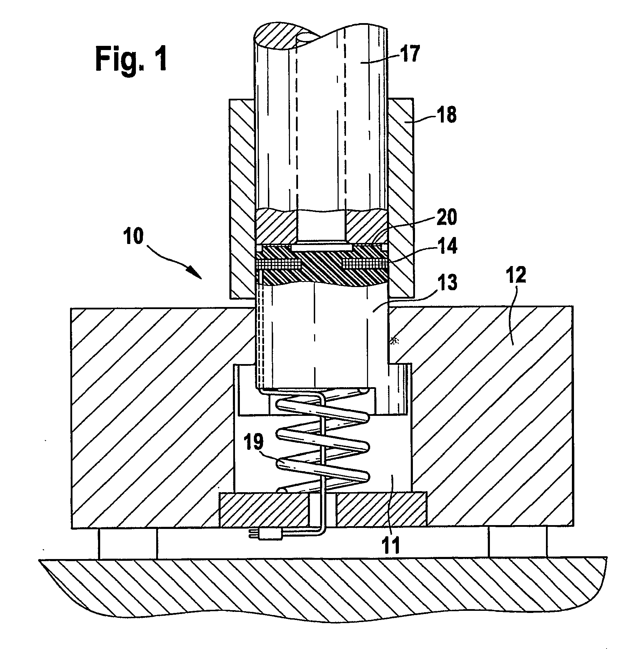

Das erfindungsgemäße Meßverfahren beruht auf dem sogenannten Induktiv-Wirbelstrommessprinzip. Eine mögliche Vorrichtung zur Durchführung des Verfahrens ist aus DE 196 52 750 C2 bekannt. In der Figur 1 ist ein dafür verwendeter Sensor 10 konstruktiv dargestellt. In dieser Darstellung ist ein Bauteil 17 auf einem Spulenkörper 13 aufgesetzt, hingegen ist beim erfindungsgemäßen Verfahren eine berührungsfreie Messung möglich. Der Sensor 10 ist in der Ausnehmung 11 eines Grundkörpers 12 angeordnet und besteht aus einem Spulenkörper 13 auf dem eine von einem Wechselstrom durchflossene Spule 14 angebracht ist. Die Spule 14 kann zum Beispiel als Flachspule oder Ringspule ausgebildet sein. Der Spulenkörper 13 besteht vorzugsweise aus elektrisch nicht leitendem und nicht ferromagnetischem Material, zum Beispiel Kunststoff, und wird nahezu reibungsfrei in der Ausnehmung 11 geführt. Das zu überwachende Bauteil 17 ist in einen Führungskörper 18 eingebracht, der das Bauteil 17 und die Spule 14 zueinander positioniert. Mit Hilfe einer Feder 19 wird der Spulenkörper 13 und somit die Spule 14 gegen die Oberfläche des Bauteils 17 gedrückt. Die Oberfläche weist die zu bestimmende Schicht auf. Beim Bauteil 17 kann es sich zum Beispiel um den Stutzen eines Einspritzventils handeln, wobei die Schicht 20 dann eine Chromschicht darstellt. Fließt durch die Spule 14 ein Wechselstrom, so wird ein magnetisches Wechselfeld erzeugt, das sowohl die Chromschicht als auch die darunterliegende Materialschicht aus ferromagnetischem Material des Bauteils 17 durchdringt. In der Chromschicht wirkt dann nur der Wirbelstromeffekt, während im ferromagnetischen Material des Bauteils 17 der Induktiv- und Wirbelstromeffekt wirksam sind. Im folgenden werden nun die jeweiligen Meßeffekte einzeln erläutert, die auftreten würden, wenn das jeweilige andere Teil nicht vorhanden wäre. Wird die Spule 14 von einem Wechselstrom durchflossen und erfaßt das magnetische Wechselfeld der Spule 14 nur ein elektrisch gut leitendes aber nicht ferromagnetisches Material, d. h. nur die Chromschicht würde vom magnetischen Wechselfeld der Spule 14 erfaßt, so wirkt nur der sog. Wirbelstromeffekt. Aufgrund der sich in dem elektrisch gut leitenden, aber nicht ferromagnetischen Material ausbildenden Wirbelströme ergibt sich eine Verminderung der Induktivität der Spule 14.

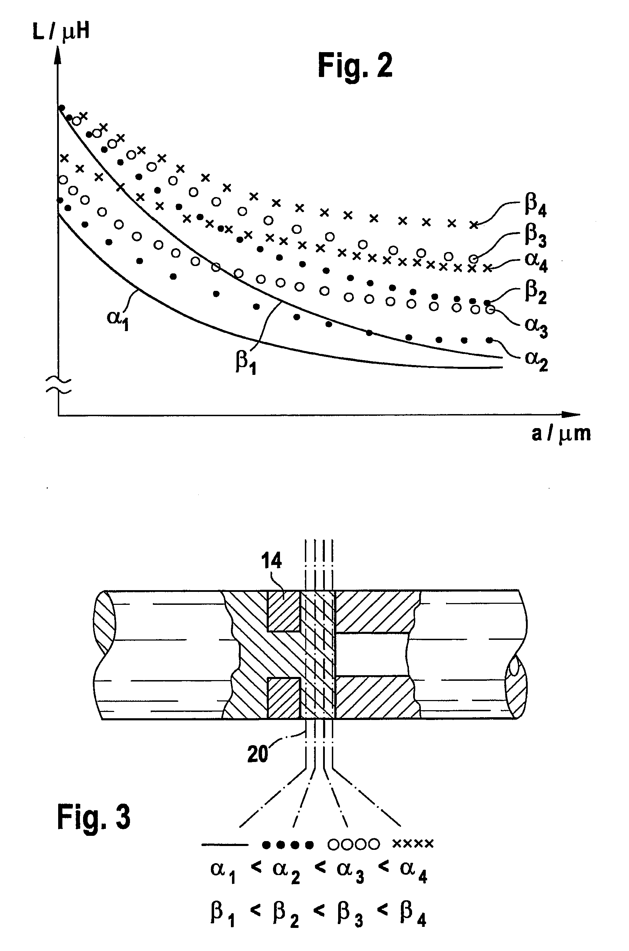

Im folgenden wird nun die Wirkung des magnetischen Feldes der von einem Wechselstrom durchflossenen Spule 14 auf das ihr gegenüberliegende ferromagnetische Material, d. h. auf das Material des Bauteils 17 beschrieben. Das magnetische Wechselfeld der von dem Wechselstrom durchflossenen Spule 14 erfaßt das Material des Bauteils 17. Es sei darauf hingewiesen, daß bei elektrisch leitendem und ferromagnetischem Material sowohl der ferromagnetische Effekt als auch der Wirbelstromeffekt wirkt. Während der Wirbelstromeffekt eine Verminderung der Induktivität der Meßspule 14 hervorruft, bewirkt der ferromagnetische Effekt, in dieser Schrift auch Induktiv-Effekt genannt, eine Erhöhung der Induktivität der Meßspule 14. Welcher von beiden Effekten überwiegt, ist primär von der Frequenz des Wechselstroms, der die Spule 14 durchfließt, und von der Stoffbeschaffenheit des Bauteils 17 abhängig. Überträgt man diese beiden Meßeffekte auf das Bauteil 17 mit der Chromschicht, so läßt sich feststellen, daß je dicker die Chromschicht ist, desto schwächer bildet sich das Magnetfeld aus und damit ist die Induktivität der Spule 14 schwächer. In der Figur 2 ist mit $\alpha 1$ eine entsprechende Meßkurve dargestellt, die den abnehmenden Verlauf der Induktivität der Meßspule 14 über die zunehmende Dicke a der Chromschicht darstellt.

Der Verlauf der Meßkurve der Induktivität L über der Schichtdicke a hängt aber von der stofflichen Beschaffenheit des Bauteils 17, d. h. zum Beispiel von dem elektrischen Widerstand, der Permeabilität des Materials und vom Abstand zwischen dem Spulenkörper 13 bzw. der Spule 14 und der Oberfläche, die gemessen werden soll, ab. Verändert sich zum Beispiel bedingt durch Verschmutzungen oder durch Abnutzung des Spulenkörpers 13 der Abstand zwischen der Meßspule 14 und der Chromschicht, so ergeben sich unterschiedliche Kennlinien des Verlaufs der Induktivität L über der Schichtdicke a. In der Figur 2 sind hier verschiedene Beispiele dargestellt. Die Kennlinien $\alpha 1$, $\alpha 2$, $\alpha 3$ und $\alpha 4$ stellen hierbei den Verlauf der Induktivität L über der Schichtdicke a bei unterschiedlichem Abstand zwischen der Meßspule 14 und der zu überwachenden Chromschicht aber bei gleicher stofflicher Beschaffenheit des Bauteils 17 dar. In der Figur 3 ist hierbei die Größe des Abstandes $\alpha$ zwischen der Spule 14 und der zu überwachenden Chromschicht dargestellt. Es ist ersichtlich, daß der Abstand von $\alpha 1$ zu $\alpha 4$ immer größer wird. Die Kennlinien $\beta 1$ bis $\beta 4$ bedeuten wiederum eine Variation des Abstands zwischen der Meßspule und der zu überwachenden Chromschicht bei einer zweiten stofflichen Beschaffenheit des Bauteils 17. Aus dem Diagramm nach der Figur 2 ist erkenntlich, daß einem gemessenen Induktivitätswert L eine Vielzahl möglicher Schichtdicken zugeordnet werden kann.

Aus dem Stand der Technik ist es bekannt, aus den ermittelten Induktivitätswerten eine Normierung durchzuführen, die einen eindeutigen zuordbaren Meßwert liefert und die oben beschriebenen Messfehler weitgehend vermindert. Insgesamt werden hierfür drei Messungen durchgeführt: Jeweils eine Vor- und Nachmessung mit dem Messobjekt und eine Messung zur Normierung ausschliesslich gegenüber einer Schicht aus dem elektrisch leitenden Material. Die Messung für die Normierung muss nicht für jedes Exemplar durchgeführt werden. Es reicht im Prinzip stattdessen aus, eine Messung für die Normierung nur bei einem Sensorwechsel durchzuführen und gegebenenfalls die Messanlagen zeitlich intervallartig abzugleichen.

Das erfindungsgemäße Verfahren ermöglicht nun auch eine berührungslose Messung. Ein grundsätzliches Problem bei einer berührungsfreien Messung ist die Schwankung des Abstands zwischen dem Spulenkörper 13, und damit der Spule 14, und dem Messobjekt. In dieser Schrift wird der Abstand Spulenkörper 13 - Messobjekt auch mit der Kurzform "Abstand" oder "Luftspalt" bezeichnet. Zur Schwankung des Abstands trägt die von Null verschiedene Fertigungstoleranz des Bauteils als Messobjekt bei. In der Praxis beträgt die Fertigungstoleranz beispielsweise bei Einspritzventil-Stutzen 0,2 mm. Unterstellt man der Messanordnung eine Mindesttoleranz von 0,1 mm, dann kann der Abstand, d. h. der Luftspalt zwischen dem Spulenkörper 13 und dem Bauteil 17, von einem Exemplar zum nächsten von 0,1 mm bis 0,3 mm schwanken. Der minimale Abstand beträgt hier also 0,1 mm und der maximale Abstand 0,3 mm. Wird zur berührungsfreien Bestimmung einer Schichtdicke das Verfahren nach den aus dem Stand der Technik bekannten Mess- und Auswerteschritten durchgeführt, dann können die oben ausgeführten Abstandsschwankungen bei günstigen Messbedingungen nur geringfügig die Messgenauigkeit verschlechtern. Allerdings muss die Messung zur Normierung bei jeder Messung, einschliesslich der Vor- und Nachmessung, zusätzlich durchgeführt werden. Mit der nun folgenden Erläuterung der Widerstands- und Induktivitäts-Messmethode wird aufgezeigt, wie die Schichtdicke trotz schwankendem Luftspalt genügend genau bestimmt werden kann, ohne dabei bei jedem Messzyklus ein Normierteil am Sensor zu positionieren und eine Messung zur Normierung durchführen zu müssen. Statt wie nach bisherigem Stand der Technik zur Bestimmung einer Schichtdicke nur Induktivitätswerte der Sensorspule 14 heranzuziehen, wird vorgeschlagen, auch ihren Widerstandswert zu messen und auszuwerten.

Das erfindungsgemäße Verfahren zur Bestimmung der Dicke einer Schicht wird, wie aus dem Stand der Technik bekannt, in mehreren Mess- und Auswerteschritten durchgeführt. Vor der Beschichtung des Bauteils 17 wird in einer sog. Vormessung ein Induktivitätswert $L_{0,d,f}$ der Spule 14 ermittelt. Hierbei bedeutet der erste Index "0" zum Induktivitätswert $L_{0,d,f1}$ die Dicke der Beschichtung (0 = unbeschichtet), der zweite Index "d" der aktuelle Wert des Abstandes zwischen dem Spulenkörper 13 und dem Bauteil 17 (d noch zu bestimmen), und schliesslich der dritte Index "f" die Wechselstromfrequenz f, mit der die Spule 14 beaufschlagt wird (f wird eingestellt). Während der Messung ist die Spule 14 gerichtet auf die noch unbeschichtete, der Spule 14 zugewandten Oberfläche (Meßfläche) des Bauteils 17, wobei sich zwischen dem Spulenkörper 13 und der Oberfläche des Bauteils 17 ein Abstand d herausbildet. Der genaue Wert d des Abstandes ist zu diesem Zeitpunkt noch nicht bekannt und muss daher noch ermittelt werden. Es erfolgt eine Messung nur gegenüber dem Material des unbeschichteten Bauteils 17. Die auf die Spule 14 beaufschlagte Wechselstromfrequenz f ist eine Frequenz aus dem Hochfrequenz-Bereich, ein geeigneter Wert ist beispielsweise 4 MHz. Die Größe des Induktivitätswerts $L_{0,d,f}$ hängt weiter von der Beschaffenheit des Bauteils 17 ab, insbesondere von dessen magnetischen und elektrischen Eigenschaften. Diese Beschaffenheit des Bauteils 17 kann in einer Serienfertigung schwanken. Deshalb ist der Induktivitätswert $L_{0,d,f}$ zu Beginn des Messverfahrens für jedes einzelne Bauteil 17 zu ermitteln und auch zuordbar in einem Datenspeicher abzuspeichern.

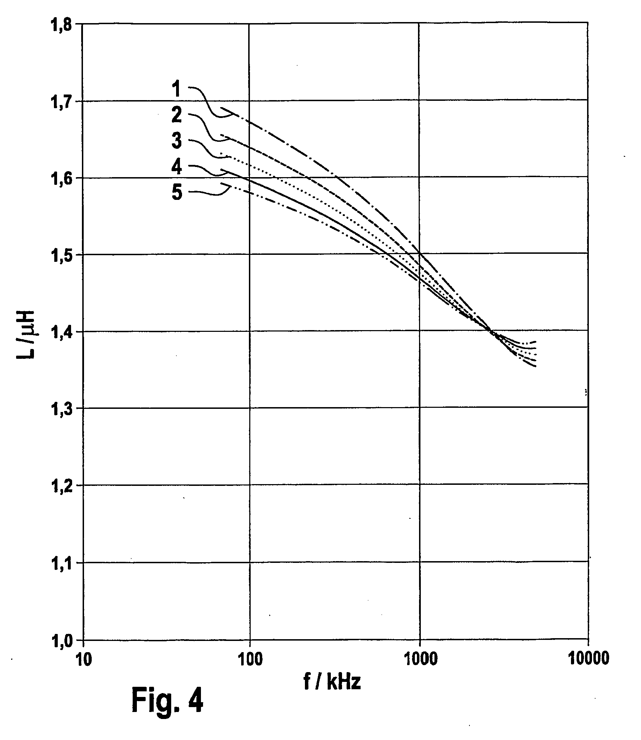

Die Vormessung der Spuleninduktivität dient zur Ermittlung eines Normwertes. Zusätzlich müssen bei einer berührungsfreien Bestimmung der Schichtdicke a eine weitere Messung durchgeführt werden, um den Abstand d zwischen dem Spulenkörper 13 und dem Bauteil 17 ermittelt zu können. Diese weitere Messung kann durch eine zusätzliche Induktivitätsmessung der Spule 14 durchgeführt werden, wobei die Spule 14 mit einer zweiten, von der ersten verschiedenen Wechselstromfrequenz f2 beaufschlagt wird. Die dadurch ermittelte Spuleninduktivität kann dann über eine Kennzahlbildung und eine zuvor aufgenommene Kennlinie in einen Abstandswert d überführt werden. Jedoch kann, wie das Diagramm in der Figur 4 zeigt, der Einsatz dieser Methode für einen bestimmten Bereich aus dem Frequenzspektrum nicht zu einem eindeutigen Ergebnis führen. In diesem Diagramm sind die gemessenen Induktivitätswerte der Spule 14 in Abhängigkeit der eingesetzten Wechselstromfrequenz f2 aufgetragen, die sich bei Messungen unbeschichteter Bauteile 17 ergeben. Der Verlauf der Kurve 1 wurde bei einem Abstand d = 0 mm aufgenommen, d. h. der Spulenkörper 13 wurde auf dem Bauteil 17 aufgesetzt ohne einen Luftspalt dazwischen. Bei den nächsten Kurven 2, 3, 4 und 5 nahm der Abstand um jeweils 0,1 mm zu. Bei einer tiefen Wechselstromfrequenz f2, beispielsweise bei 100 kHz in der Figur 4, ist der Induktivitätswert dann am höchsten, wenn der Spulenkörper 13 auf dem Bauteil 17 aufgesetzt wird. Je weiter sich die Spule 14 vom Bauteil 17 entfernt, desto geringerer werden die Werte. Bei hohen Wechselstromfrequenzen f2, beispielsweise bei 5 MHz in der Figur 4, verhält es sich genau umgekehrt. Dazwischen gibt es einen Frequenzbereich, in diesem Beispiel etwa bei 3 bis 4 MHz, in dem die Abstandsänderungen kaum unterschiedliche Induktivitätswerte der Spule 14 bewirken. Daher kann eine sichere Abstandsbestimmung mit diesen Wechselstromfrequenzen nicht durchgeführt werden. Die Wechselstromfrequenz f2 sollte folglich besser eine Frequenz aus dem Niederfrequenz-Bereich, beispielsweise 100 kHz, sein. Es wird darauf hingewiesen, dass der Frequenzbereich, in dem die Abstandsänderungen kaum unterschiedliche Induktivitätswerte der Spule 14 bewirken, abhängig vom Grundmaterial des Bauteils 17 und der Spulenform ist.

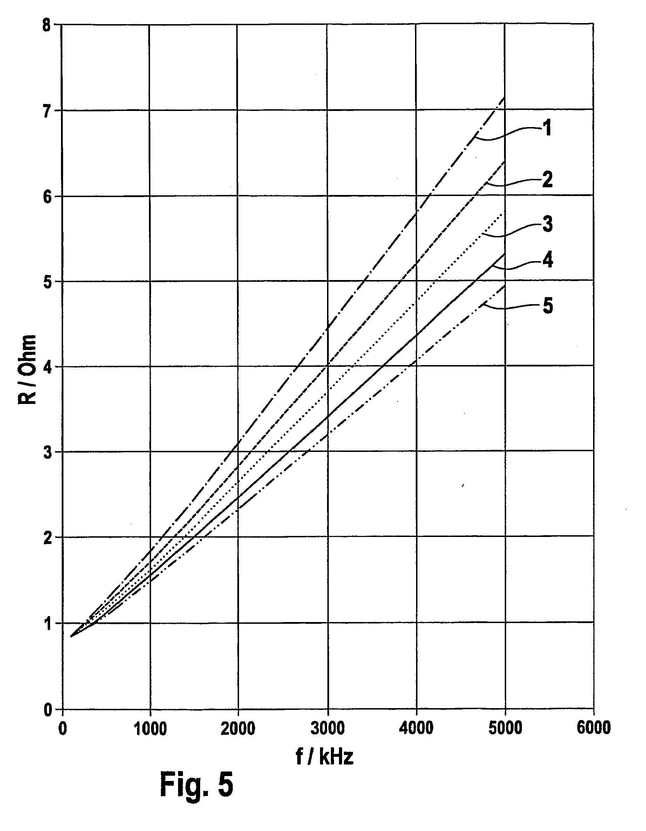

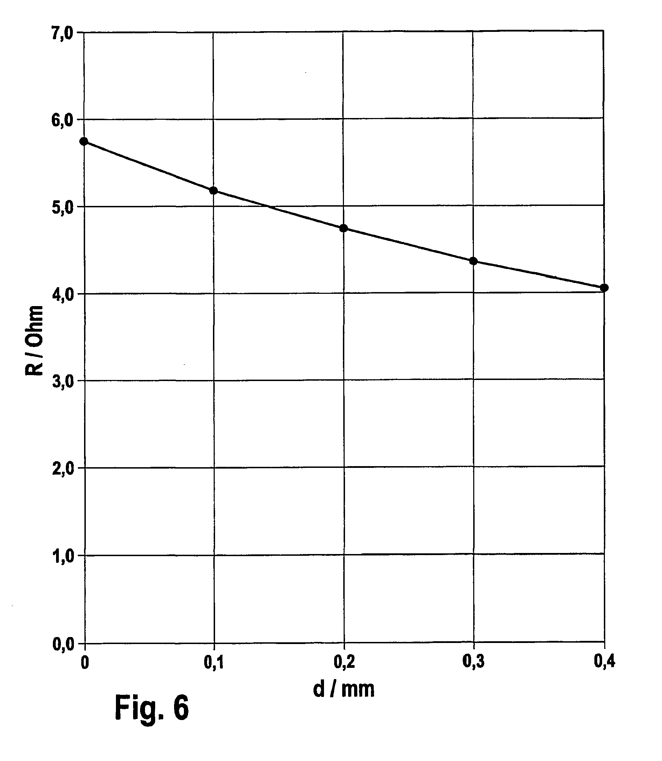

Statt einer weiteren Induktivitätsmessung der Spule 14 zur Abstandsbestimmung wird im erfindungsgemäßen Verfahren vorgeschlagen, den Wechselstromwiderstandswert R der Spule 14 zu messen. Wie in der Figur 4 repräsentiert die Kurve 1 in der Figur 5 das Messergebnis bei einem Abstand d = 0 mm, und die weiteren Kurven 2, 3, 4 und 5 bei einer Abstandszunahme um jeweils 0,1 mm. Die Kurven 1 bis 5 zeigen in der Figur 5 den Verlauf des Widerstandswertes R der Spule 14, die sich bei Messungen unbeschichteter Bauteile 17 ergeben. Auch im MHz-Bereich der eingesetzten Wechselstrom-frequenz f2 zeigen die Widerstandswerte R der Spule 14 eine ausreichende Empfindlichkeit, d. h. eine sichere Ableitung des Abstandes d aus dem gemessenen Widerstandswert R ist möglich. Trägt man den Widerstandwert R über den Abstand d auf, wobei die Spule 14 mit einer Wechselstromfrequenz von f = 4 MHz beaufschlagt wurde, so erhält man wie in Figur 6 erkennbar eine eindeutige Kennlinie. Vorteilhaft erfolgen die Vormessung der Spuleninduktivität zur Normwertermittlung und die Widerstandsmessung zur Abstandsermittlung praktisch zeitgleich, da moderne Messgeräte bei einer Spulenmessung beide Grössen zusammen erfassen.

Aus der Messung des Widerstandswertes R der Spule 14 wird mit Hilfe der zuvor aufgenommenen Kennlinie, wie in Figur 6 dargestellt, ein Abstandswert d abgeleitet und abgespeichert.

Anschließend wird nun das Bauteil 17 in einer entsprechenden Beschichtungsanlage mit einer Chromschicht versehen. Danach erfolgt eine dritte Messung, d. h. eine sog. Nachmessung, die an derselben Stelle des Bauteils 17 wie die oben erwähnten Vormessungen durchgeführt wird. Die Messvorrichtung muss dabei so beschaffen sein, dass der Abstand d bei der Vor- und Nachmessung gleich gross ist. Dabei ergibt sich ein Induktivitätswert $L_{x,d,f}$ der Meßspule 14, wobei der erste Index "x" für den zu bestimmenden Wert der Schichtdicke a, der zweite Index "d" für den Abstand zwischen dem Spulenkörper 13 und dem beschichteten Bauteil 17 und der dritte Index "f" für die auf die Spule 14 beaufschlagte Wechselstromfrequenz f steht. Vor- und Nachmessung erfolgen mit der gleichen Frequenz f, beispielsweise 4 MHz. Die Größe des Induktivitätswerts $L_{x,d,f}$ wird u. a. von der Dicke der Chromschicht und von der stofflichen Beschaffenheit des Bauteils 17 bestimmt. Es ist sicherzustellen, dass beide ermittelten Induktivitätswerte $L_{0,d,f}$ bzw. $L_{x,d,f}$ jeweils eindeutig demselben Bauteil 17 zuzuordnen sind.

Diese beiden Induktivitätswerte $L_{0,d,f}$ bzw. $L_{x,d,f}$ werden nun mit Hilfe eines Algorithmuses in einen Normwert umgeformt, d. h. in eine dimensionslose Kennzahl, die einer entsprechenden Schichtdicke a zuordbar ist. Dieser Normwert sei hier mit Messwert $M_e$ bezeichnet. Um diese Normwertbildung durchführen zu können, müssen die Induktivi-tätswerte $L_{\infty,AB,f}$ und $L_{0,AB,f}$ ermittelt werden bzw. sind diese Werte bereits gemessen und abgespeichert. Den Indukti-vitätswert $L_{\infty,AB,f}$ erhält man, wenn an einem Messobjekt eine Messung ausschließlich gegenüber einer Chromschicht durchgeführt wird, wobei der Wert des Abstands d zwischen dem Spulenkörper 13 und dem Messobjekt AB beträgt. Die Oberfläche des Messobjektes muss dabei eine so dicke Chromschicht aufweisen, dass sie praktisch das gesamte Magnetfeld der Spule 14 abschirmt, so dass im ferromagnetischen Grundstoff des Messobjektes weder der induktive Effekt noch der Wirbelstromeffekt sich auswirken kann. Gegebenenfalls könnte beim Messobjekt an Stelle von Chrom auch ein anderer elektrisch leitender, jedoch nicht ferromagnetischer Stoff als Ersatz verwendet werden. Den Induktivitätswert $L_{0,AB,f}$ erhält man, wenn eine Messung ausschließlich gegenüber an einem Messobjekt aus ferromagnetischen Material durchgeführt wird, wobei der Wert des Abstands d zwischen dem Spulenkörper 13 und dem Messobjekt AB beträgt. Für beide Induktivitätswerte $L_{\infty,AB,f}$ und $L_{0,AB,f}$ wird die hochfrequente Wechselstromfrequenz f eingesetzt. Entsprechend der Gleichung 1 wird nun der Normwert oder Messwert $M_e$ ermittelt:

$$M_e = B \cdot \frac{L_{x,d,f} - L_{0,d,f}}{L_{\infty,AB,f} - L_{0,AB,f}} \qquad [1]$$

wobei

$L_{x,d,f}$ = Induktivitätswert der Nachmessung

$L_{0,d,f}$ = Induktivitätswert der Vormessung

$L_{\infty,AB,f}$ = Induktivitätswert der Spule 14 bei einer Messung ausschließlich gegenüber einem Messobjekt aus dem elektrisch leitenden Material, wobei der Wert des Abstands zwischen dem Spulenkörper 13 und dem Messobjekt AB beträgt

$L_{0,AB,f}$ = Induktivitätswert der Spule 14 bei einer Messung ausschließlich gegenüber einem Messobjekt aus dem ferromagnetischen Material, wobei der Wert des Abstands zwischen dem Spulenkörper 13 und dem Messobjekt AB beträgt

B = konstanter Faktor

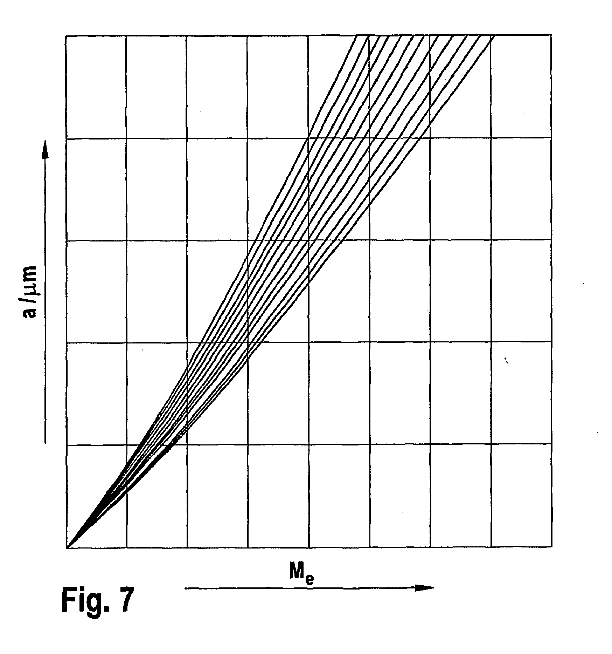

Der konstante Faktor B kann eine beliebige positive Zahl sein, praktischerweise ist B ein Vielfaches von 10, beispielsweise 1000. Als ein möglicher Wert AB des Abstands d zwischen dem Spulenkörper 13 und dem Messobjekt kann der halbe Wert der Summe vom minimalen und maximalen Abstand zwischen dem Spulenkörper 13 und dem Messobjekt ausgewählt werden. Ein typischer Wert aus der Praxis beträgt AB = 0,2 mm. Mit diesen konkreten Werten für den konstanten Faktor B und AB und den gemessenen Induktivitätswerten werden nach der oben stehenden Gleichung (1) - im Gegensatz zum bisherigen Messverfahren mit nur einer Justierkurve aus dem Stand der Technik - mehrere Justierkurven aufgenommen, die jeweils für einen konkreten, voneinander unterschiedlichen Abstand d gilt. Als Parameter dient dabei der Abstand. Die Gesamtheit der beispielsweise zwölf Justierkurven bildet eine Justierkurvenschar, die in Figur 7 dargestellt wurde. Jede einzelne Justierkurve repräsentiert einen bestimmten Abstandswert und zeigt für diesen Abstandswert den Verlauf der Schichtdicke a über einen Bereich der Normwerte. Bei der Umwandlung des Messwertes $M_e$ in einen Schichtdickenwert a wird natürlich diejenige Justierkurve ausgewählt, deren Abstandsparameterwert die geringste Abweichung zum ermittelten Wert des Abstandes d aufweist. Im Idealfall ist die geringste Abweichung gleich Null.

Dieses Messverfahren kann angewandt werden, wenn die elektrischen und magnetischen Eigenschaften der zu messenden Teile - exemplarbezogen - genügend konstant sind. Es empfiehlt sich, diese Konstanz zu überprüfen.

Bei induktiven Wechselstrom-Schichtdicken-Messungen muss die Messanlage so ausgelegt sein, dass keine Verfälschung des Messsignals durch induktive oder kapazitive Koppelimpedanzen entsteht, wenn diese berührt oder durch elektromagnetische Einkopplung verändert wird (die Erdungsproblematik ist zu beachten). Ob sich ein relevanter Berührungsmessfehler ausbildet, hängt von der Bauart der Messanlage und.von der Trägerfrequenz ab. Dabei gilt tendenziell: Je höher die Trägerfrequenz, desto eher besteht die Gefahr des Entstehens von Berührungsfehlern. (Diese Zusammenhänge gelten auch für die in DE 196 52 750 C2 und in anderen Patentschriften beschriebenen Messverfahren, die mit dem gleichen physikalischen Grundprinzip arbeiten).

Dazu noch folgender Hinweis: Nicht nur das direkte Berühren der Messgeräte und des Sensors können zu Messfehlern führen, sondern auch das indirekte Berühren. Ein Beispiel fürs indirekte Berühren: Die Zuführkabel vom Messgerät zum Sensor liegen auf oder in der Nähe einer Metallplatte. Wird diese Metallplatte berührt, kann dies zu Messfehlern führen, auch wenn die Berührungsstelle relativ weit von den Kabelpositionen entfernt ist. Gegebenenfalls muss das Entstehen solcher Messfehler mit Hilfe bekannter Methoden verhindert werden.

## Patentansprüche

**1.** Verfahren zur berührungsfreien Bestimmung einer Dicke einer Schicht (20) aus elektrisch leitendem Material, die auf einem Bauteil (17) aus ferromagnetischem Material aufgebracht ist, wobei mit Hilfe mindestens einer von einem Wechselstrom durchflossenen und auf einem Spulenkörper (13) angebrachten Meßspule (14), deren Induktivitäts- und Widerstandswerte ausgewertet werden, folgende Meßschritte ablaufen:

- Ermittlung des Induktivitätswertes $L_{0,d,f}$ der Spule (14) bei einer Messung ausschließlich gegenüber einem Bauteil (17) als Messobjekt aus dem ferromagnetischen Material, wobei die Spule (14) mit einer Wechselstromfrequenz f beaufschlagt wird und der Abstand zwischen dem Spulenkörper (13) und dem Messobjekt d beträgt;
- Ermittlung des Widerstandswertes $R_{0,d,f}$ der Spule (14) bei einer Messung ausschließlich gegenüber dem Bauteil (17) als Messobjekt aus dem ferromagnetischen Material, wobei die Spule (14) mit der Wechselstromfrequenz f beaufschlagt wird und der Abstand zwischen dem Spulenkörper (13) und dem Messobjekt d beträgt;
- Umwandlung des Widerstandswertes $R_{0,d,f}$ mit Hilfe einer Abstandskennlinie in den Wert des Abstands d;
- Ermittlung des Induktivitätswertes $L_{x,d,f}$ der Spule (14) bei einer Messung gegenüber der zu bestimmenden Schicht (20), wobei die Spule (14) mit der Wechselstromfrequenz f beaufschlagt wird und der Abstand zwischen dem Spulenkörper (13) und dem beschichteten Bauteil (17) d beträgt;
- Umwandlung der ermittelten Induktivitätswerte $L_{0,d,f}$ und $L_{x,d,f}$ in einen dimensionslosen Messwert $M_e$;
- Umwandlung des Messwertes $M_e$ mit Hilfe einer Justierkurvenschar unter Berücksichtigung des ermittelten Wertes des Abstands d in einen Schichtdickenwert a.

**2.** Verfahren nach Anspruch 1,
**dadurch gekennzeichnet,**
**dass** der dimensionslos Messwert $M_e$ mit Hilfe der folgenden Gleichung ermittelt wird:

$$M_e = B \cdot \frac{L_{x,d,f} - L_{0,d,f}}{L_{\infty,AB,f} - L_{0,AB,f}}$$

wobei

$L_{x,d,f}$ = Induktivitätswert der Nachmessung
$L_{0,d,f}$ = Induktivitätswert der Vormessung
$L_{\infty,AB,f}$ = Induktivitätswert der Spule (14) bei einer Messung ausschließlich gegenüber einem Messobjekt aus dem elektrisch leitenden Material, wobei der Wert des Abstands d zwischen dem Spulenkörper (13) und dem Messobjekt AB beträgt
$L_{0,AB,f}$ = Induktivitätswert der Spule (14) bei einer Messung ausschließlich gegenüber einem Messobjekt aus dem ferromagnetischen Material, wobei der Wert des Abstands d zwischen dem Spulenkörper (13) und dem Messobjekt AB beträgt
B = konstanter Faktor

3. Verfahren nach Anspruch 2,
   **dadurch gekennzeichnet,**
   **dass** der konstante Faktor B 1000 beträgt.

4. Verfahren nach einem der Ansprüche 1 bis 3,
   **dadurch gekennzeichnet,**
   **dass** die Wechselstromfrequenz f eine Frequenz aus dem Hochfrequenz-Bereich, beispielsweise 4 MHz, ist.

5. Verfahren nach einem der Ansprüche 2 bis 4,
   **dadurch gekennzeichnet,**
   **dass** als Wert AB des Abstands d der halbe Wert der Summe vom minimalen und maximalen Abstand zwischen dem Spulenkörper (13) und dem Messobjekt ausgewählt wird.

6. Verfahren nach einem der Ansprüche 1 bis 5,
   **dadurch gekennzeichnet,**
   **dass** die Justierkurvenschar mehrere Justierkurven aufweist, die jeweils für einen konkreten, voneinander unterschiedlichen Abstand d gilt.

7. Verfahren nach Anspruch 6,
   **dadurch gekennzeichnet,**
   **dass** aus der Justierkurvenschar diejenige Justierkurve zur Umwandlung des Messwertes $M_e$ in Schichtdickenwert a ausgewählt wird, deren Abstandsparameterwert die geringste Abweichung zum ermittelten Abstand d aufweist.

**Claims**

1. Method for contactlessly determining a thickness of a layer (20) composed of electrically conductive material which has been applied on a component (17) composed of ferromagnetic material, the following measuring steps proceeding with the aid of at least one measuring coil (14) through which an alternating current flows and which is fitted on a coil former (13) and the inductance and resistance values of which are evaluated:

   - determining the inductance value $L_{0,d,f}$ of the coil (14) during a measurement exclusively with respect to a component (17) as measurement object composed of the ferromagnetic material, an alternating current frequency f being applied to the coil (14) and the distance between the coil former (13) and the measurement object being d;
   - determining the resistance value $R_{0,d,f}$ of the coil (14) during a measurement exclusively with respect to the component (17) as measurement object composed of the ferromagnetic material, the alternating current frequency being applied to the coil (14) and the distance between the coil former (13) and the measurement object being d;
   - converting the resistance value $R_{0,d,f}$ into the value of the distance d with the aid of a distance characteristic curve;
   - determining the inductance value $L_{x,d,f}$ of the coil (14) during a measurement with respect to the layer (20) to be determined, the alternating current frequency f being applied to the coil (14) and the distance between the coil former (13) and the coated component (17) being d;
   - converting the inductance values $L_{0,d,f}$ and $L_{x,d,f}$ determined into a dimensionless measured value $M_e$;
   - converting the measured value $M_e$ into a layer thickness value a with the aid of a family of adjustment curves taking account of the determined value of the distance d.

2. Method according to Claim 1,
   **characterized**
   **in that** the dimensionless measured value $M_e$ is determined with the aid of the following equation:

$$M_e = B \cdot \frac{L_{x,d,f} - L_{0,d,f}}{L_{\infty,AB,f} - L_{0,AB,f}}$$

where

L$_{x,d,f}$ = inductance value of the post-measurement
L$_{0,d,f}$ = inductance value of the pre-measurement
L$_{\infty, AB,f}$ = inductance value of the coil (14) during a measurement exclusively with respect to a measurement object composed of the electrically conductive material, the value of the distance d between the coil former (13) and the measurement object being AB
L$_{0,AB,f}$ = inductance value of the coil (14) during a measurement exclusively with respect to a measurement object composed of the ferromagnetic material, the value of the distance d between the coil former (13) and the measurement object being AB
B = constant factor

3. Method according to Claim 2,
   **characterized**
   **in that** the constant factor B is 1000.

4. Method according to one of Claims 1 to 3,
   **characterized**
   **in that** the alternating current frequency f is a frequency from the high-frequency range, for example 4 MHz.

5. Method according to one of Claims 2 to 4,
   **characterized**
   **in that** half the value of the sum of the minimum and maximum distance between the coil former (13) and the measurement object is selected as the value AB of the distance d.

6. Method according to one of Claims 1 to 5,
   **characterized**
   **in that** the family of adjustment curves has a plurality of adjustment curves each applying to a concrete distance d that differs from one another.

7. Method according to Claim 6,
   **characterized**
   **in that** from the family of adjustment curves that adjustment curve whose distance parameter value has the smallest deviation with respect to the determined distance d is selected for converting the measured value $M_e$ into the layer thickness value a.

**Revendications**

1. Procédé de détermination sans contact de l'épaisseur d'une couche (20) en une matière électro conductrice appliqué sur un composant (10) en matière ferromagnétique, selon lequel, à l'aide d'au moins une bobine de mesure (14) traversée par un courant alternatif et portée par un corps de bobine (13), on exploite son inductance et sa résistance, procédé selon lequel on effectue les étapes de mesure suivantes :

   - détermination de l'inductance L $_{o, d, f}$ de la bobine (14) par une mesure exclusive par rapport à un composant (17) comme objet de mesure en matière ferromagnétique, la bobine (14) recevant un courant alternatif de fréquence f, la distance entre le corps de bobine (13) et l'objet de mesure étant égale à (d),

- détermination de la résistance $R_{o,d,f}$ de la bobine (14) pour une mesure faite exclusivement par rapport à un composant (17) comme objet de mesure en matière ferromagnétique, la bobine (14) recevant un courant alternatif de fréquence f, la distance entre le corps de bobine (13) et l'objet de mesure étant égale à (d),
- conversion de la résistance $R_{o,d,f}$ à l'aide d'une caractéristique de distance pour obtenir la valeur de la distance (d),
- détermination de l'inductance $L_{x,d,f}$ de la bobine (14) dans le cas d'une mesure par rapport à la couche (20) à déterminer, la bobine (14) recevant un courant alternatif de fréquence f et la distance entre le corps de bobine (13) et le composant revêtu (17) étant égale à (d),
- conversion des inductances obtenues $L_{o,d,f}$ et $L_{x,d,f}$ en une mesure sans dimension $(M_e)$,
- conversion de la valeur de mesure $(M_e)$ à l'aide d'un faisceau de courbes d'ajustage en tenant compte de la valeur déterminée de la distance (d) en une épaisseur de couche (a).

2. Procédé selon la revendication 1,
   **caractérisé en ce qu'**
   on détermine la valeur de mesure $(M_e)$ sans dimension en appliquant l'équation suivante :

$$M_e = \frac{L_{x,d,f} - L_{o,d,f}}{L_{\infty,AB,f} - L_{o,AB,f}}$$

dans laquelle

$L_{x,d,f}$ = inductance de la mesure postérieure.
$L_{o,d,f}$ = inductance de la mesure antérieure
$L_{\infty,AB,f}$ = inductance de la bobine (14) lors de la mesure, exclusivement par rapport à un objet de mesure en matière électroconductrice, la valeur de la distance (d) entre le corps de la bobine (13) et l'objet de mesure étant égale à AB,
$L_{o,AB,f}$ = inductance de la bobine (14) dans le cas d'une mesure faite exclusivement par rapport à un objet de mesure en une matière ferromagnétique, la valeur de la distance (d) entre le corps de bobine (13) et l'objet de mesure étant égale à AB,
B = coefficient constant.

3. Procédé selon la revendication 2,
   **caractérisé en ce que**
   le coefficient constant B est égal à 1.000.

4. Procédé selon l'une des revendications 1 à 3,
   **caractérisé en ce que**
   la fréquence de courant alternatif est une haute fréquence, par exemple 4 MHz.

5. Procédé selon l'une des revendications 1 à 4,
   **caractérisé en ce que**
   la valeur AB de la distance (d) est de la moitié de la somme de la distance minimale et de la distance maximale entre le corps de la bobine (13) et l'objet de mesure.

6. Procédé selon l'une des revendications 1 à 5,
   **caractérisé en ce que**
   le faisceau de courbes d'ajustage comporte plusieurs courbes d'ajustage qui s'appliquent chacune à une distance (d), pratique, différente des autres.

7. Procédé selon la revendication 6,
   **caractérisé en ce qu'**
   à partir du faisceau de courbes d'ajustage, on sélectionne la courbe d'ajustage pour convertir la valeur de mesure $(M_e)$ en une valeur de densité de couche (a), le paramètre de distance correspondant à la plus petite déviation par rapport à la distance (d) obtenue.

**Fig. 1**

**Fig. 2**

**Fig. 3**

$$\alpha_1 < \alpha_2 < \alpha_3 < \alpha_4$$
$$\beta_1 < \beta_2 < \beta_3 < \beta_4$$

Fig. 4

**Fig. 5**

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19652750 C2

- WO 9958923 A